Europäisches Patentamt

European Patent Office

Office européen des brevets

(11) Publication number: **0 405 063 A2**

# EUROPEAN PATENT APPLICATION

(21) Application number: **90106143.2**

(22) Date of filing: **30.03.90**

(51) Int. Cl.5: **H01L 29/784, H01L 29/91**

(30) Priority: **29.04.89 JP 111654/89**

(43) Date of publication of application:
**02.01.91 Bulletin 91/01**

(84) Designated Contracting States:
**DE FR GB**

(71) Applicant: **FUJITSU LIMITED**
**1015, Kamikodanaka Nakahara-ku**
**Kawasaki-shi Kanagawa 211(JP)**

(72) Inventor: **Gotou, Hiroshi**
**16-2-105 Nobidome 1-chome**
**Niiza-shi, Saitama 352(JP)**

(74) Representative: **Seeger, Wolfgang, Dipl.-Phys.**
**Georg-Hager-Strasse 40**
**D-8000 München 70(DE)**

(54) An insulated-gate fet on an soi-structure.

(57) An SOI-type insulated-gate FET is constituted such that an electrical resistance across pn-junction of the source region is less than that across pn-junction of the drain region, by being provided with a metal dopant, such as aluminum or tungsten; semiconductor dopant excessively doped more than normal source region; an amorphous source region; or a layer formed of a material having different thermal expansion coefficient from the thermal expansion coefficient of material forming the source region, upon the source region. In a thus fabricated transistor, there is generated a carrier generation centre or a precipitation of the impurities at a pn-junction formed between the source region and the semiconductor substrate. Thus, a current path is formed across the pn-junction of the source region in both the forward and reverse directions of a diode of the pn-junction so as to substantially eliminate the potential difference between the source region and the semiconductor substrate. Accordingly, a kink phenomena in the drain voltage-current characteristics is eliminated.

EP 0 405 063 A2

## AN INSULATED-GATE FET ON AN SOI-STRUCTURE

### BACKGROUND OF THE INVENTION

Field of the Invention

The present invention relates to an insulated-gate FET (field effect transistor), and more particularly to an insulated-gate FET formed on a semiconductor substrate of an SOI (silicon on insulator) structure.

Description of the Related Art

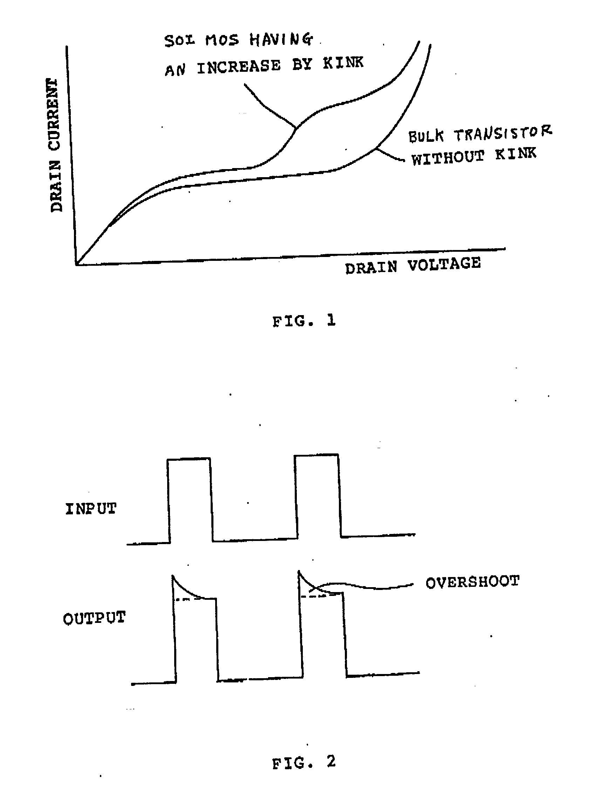

It has been well known that there appears a kink phenomena on drain voltage-current characteristics of a MOS (metal-oxide semiconductor) FET fabricated on an SOI substrate. The relation of the drain current versus drain voltage while the gate voltage is kept constant is shown in FIG. 1, where an FET on SOI exhibits an increase in the drain current in comparison with a bulk transistor inherently having no kink. Transistors having the kink phenomena cause overshoot in the output voltage-form of a source-follower circuit when a pulse voltage is input to the gate electrode, as shown in FIG. 2.

It has been known that the kink phenomena does not appear if the semiconductor substrate on the SOI substrate is as thin as approximately 1000 Å, however, does appear when the semiconductor substrate is thicker than 3000 Å. However, there is a problem in that the manufacture of a semiconductor substrate as thin as 1000 Å on an SOI substrate is very difficult; accordingly, the production cost is far beyond that of approximately 1 μm thick semiconductor substrate on SOI substrate. Therefore, it has been requested to develop a semiconductor device structure which causes no kink phenomena even if the semiconductor substrate is approximately 1 μm thick. It is supposed that the reason of causing the kink phenomena is such that a part, beneath the channel and in the vicinity of the insulating substrate, of the semiconductor substrate becomes floating so as to cause fluctuation in the potential during the operation.

In order to suppress the potential fluctuation of the semiconductor substrate, a contact electrode to lead out the substrate is provided to a region extending aside from the channel as disclosed in Japanese Unexamined Patent publication Tokukai Sho 52-35982 as well as described below.

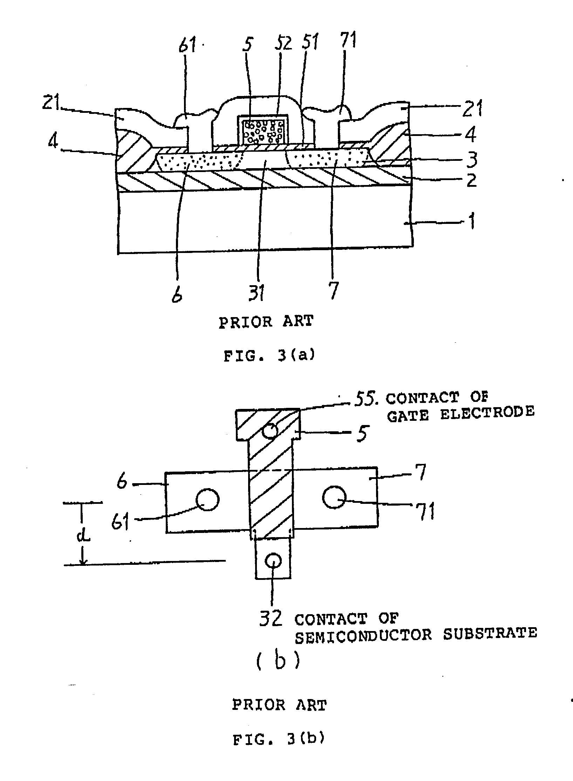

FIG. 3(a) is a cross-sectional side view of main portion of a prior art transistor. FIG. 3(b) is a plan view showing the electrodes layout. In FIGs. 3, the numeral 1 denotes a supporting substrate; the numeral 2 denotes an insulating layer; the numeral 21 denotes an insulating film; the numeral 3 denotes a semiconductor substrate; the numeral 31 denotes a channel; the numeral 32 denotes a substrate contact; the numeral 4 denotes an element isolation region; the numeral 5 denotes a gate; the numeral 51 denotes a gate insulating oxide film; the numeral 52 denotes an oxide film; the numeral 55 denotes a gate electrode contact; the numeral 6 denotes a source region; the numeral 61 denotes a source contact; the numeral 7 denotes a drain region; and the numeral 71 denotes a drain contact. An SOI substrate is composed of supporting substrate 1, insulating layer 2 and semiconductor substrate 3. As seen in FIG. 3(b), a part of semiconductor substrate extending from channel 31 located beneath the gate electrode 5 is provided with a substrate contact 32. The substrate contact 32 is connected to the source contact 61 via an external wiring and is typically grounded. This configuration has disadvantages that the long distance d (denoted in FIG. 3-(b)) between channel 31 and substrate contact 32 causes an increase in the electrical resistance, which is likely to cause fluctuation of the channel potential, accordingly, the kink phenomena cannot be completely suppressed. Furthermore, there is a disadvantage that the provision of the substrate contact requires an additional mask process as well as an increase in the area occupied by each transistor.

### SUMMARY OF THE INVENTION

It is a general object of the invention, therefore to provide an SOI-type insulated-gate FET having reduced kink phenomena in drain current characteristics.

It is another object of the invention to provide an SOI-type insulated-gate FET which can be integrated in high density.

An SOI-type insulated-gate FET according to the present invention is constituted such that an electrical resistance across the pn-junction of the source region is less than that across the pn-junction of the drain region, by being provided with a metal dopant, such as aluminum or tungsten; semiconductor dopant excessively doped more than normal source region; an amorphous source region; or a layer formed of a material having different thermal expansion coefficient from the thermal expansion coefficient of material forming the source region, upon the source region. Thus reduced electrical resistance providing a current path across the pn-junction of the source region substantially eliminates the potential difference between the source region and the semiconductor substrate.

The above-mentioned features and advantages of the present invention, together with other objects and advantages, which will become apparent, will be more fully described hereinafter, with reference being made to the accompanying drawings which form a part hereof, wherein like numerals refer to like parts throughout.

## BRIEF DESCRIPTION OF THE DRAWINGS

FIG. 1 is a plot of drain voltage versus drain current characteristics of transistors with and without kink phenomena;

FIG. 2 shows output pulse waveforms of a source-follower circuit, having overshoot caused from the kink phenomena;

FIG. 3(a) is a cross-sectional side view of a prior art SOI-type MOS transistor;

FIG. 3(b) is a plan view of FIG. 3(a) prior art transistor;

FIGs. 4 are cross-sectional side views at steps of fabricating a first preferred embodiment structure of the present invention;

FIG. 5 is a plan view of FIGs. 4 transistor;

FIG. 6 is a graph of drain voltage versus drain current characteristics of FIGs. 4 transistor;

FIGs. 7 are cross-sectional side views of the steps for fabricating a second preferred embodiment structure of the present invention;

FIG. 8 is a graph of drain voltage versus drain current characteristics of FIGs. 7 transistor;

FIGs. 9 are cross-sectional side views of the steps for fabricating a sixth preferred embodiment structure of the present invention;

FIG. 10 is a graph of drain voltage versus drain current characteristics of FIGs. 9 transistor ; and

FIG. 11 is a cross-sectional side view of a seventh preferred embodiment structure of the present invention.

## DESCRIPTION OF THE PREFERRED EMBODIMENTS

Referring to preferred embodiments, the present invention is hereinafter described.

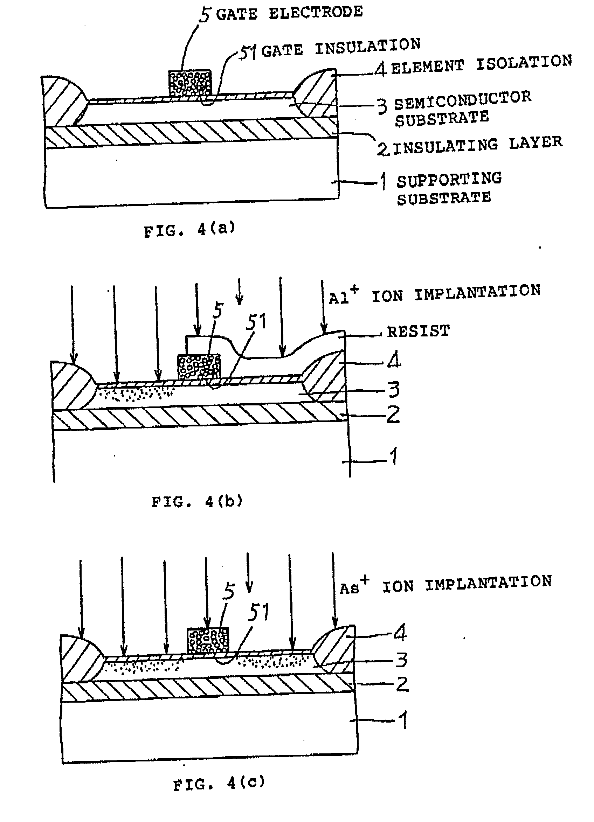

In fabricating an SOI-type insulated-gate transistor of a first preferred embodiment of the present invention, a typically 1 $\mu$m thick insulating layer 2 formed of $SiO_2$ (silicon dioxide) and a typically 1 $\mu$m thick semiconductor substrate 3 of p-type silicon thereon are formed upon a typically 500 $\mu$m thick supporting substrate formed of silicon, according to a wafer bonding and thinning method or SIMOX (separation by implanted oxygen) technique so as to form an SOI substrate, as shown in FIG. 4(a). A typically 1 $\mu$m thick element-isolation 4 for isolating, for example, adjacent transistors, a typically 300 Å thick gate insulation 51 and a gate electrode 5 of polycrystalline silicon are formed on the SOI substrate according to a well-known technique. Next, as shown in FIG. 4(b), metal ion, for example, aluminum ion ($Al^+$) is implanted into a part of the semiconductor substrate 3 to be a source region at the condition of typically 50 keV and $1 \times 10^{15}$ cm$^{-2}$ in dose, while the other portion is masked with resist. Next, as shown in FIG. 4(c), after removing the resist, arsenic ions ($As^+$) as n-type dopant are implanted into the entire surface at the condition of typically 100 keV and $5 \times 10^{15}$ cm$^{-2}$ in dose. Next, as shown in FIG. 4(d), exposed surfaces of the polycrystalline silicon gate electrode 5 are oxidized according to a well-known heat process so as to form a 500 Å insulating oxide films 52. During this heat process for the oxidization, the ion-implanted impurities are diffused so that the arsenic impurity forms a source region 6 and a drain region 7 and the aluminum impurity reaches a pn-junction formed between source region 6 and semiconductor substrate 3, while the portion beneath the gate electrode 5 becomes a channel 31. Thus, impurity concentrations are approximately $1.5 \times 10^{20}$ cm$^{-3}$ of arsenic in the drain and source regions and $3 \times 10^{19}$

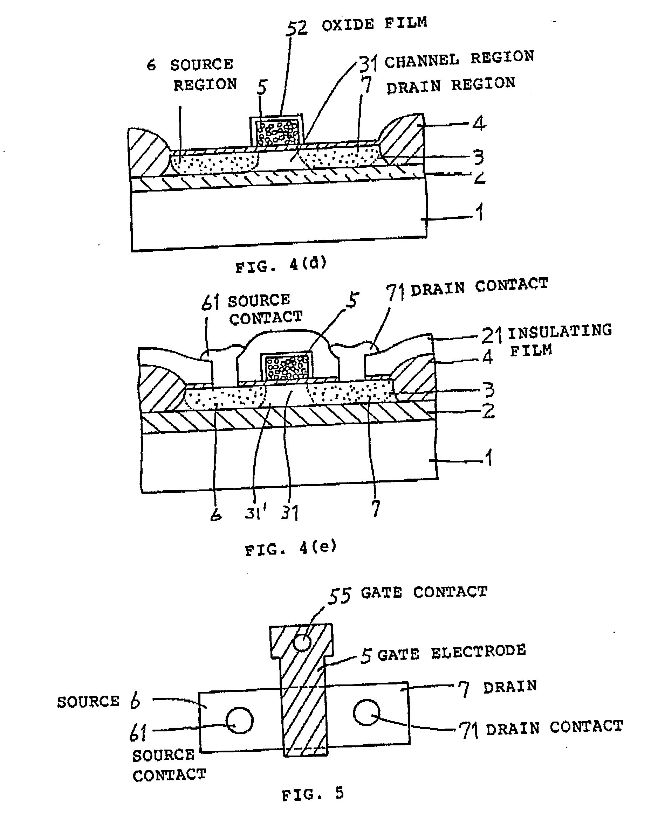

$cm^{-3}$ of aluminum additionally in the source region 6. Next, as shown in FIG. 4(e), an insulating film 21 formed of PSG (phospho silicate glass) is deposited typically as thick as 1 $\mu$m upon the entire surface of thus fabricated substrate, according to well-known technique. Insulating film 21 is provided with contact holes so as to expose source region 6, drain region 7 and gate electrode 5 according to a well-known photo-lithography technique. According to a well-known technique, after typically aluminum is sputtered upon the entire surface, the aluminum film is patterned so as to form a source contact 61, a drain contact 71 and a gate contact 55. Plan view of these contacts are shown in FIG. 5, where the prior art contact 32 of the semiconductor substrate is no more provided.

The boundary between semiconductor substrate 31 and source region 6 doped with the arsenic forms a pn-junction. The metal impurity, i.e. aluminum, diffused into the source region 6 further reaches the pn-junction, where the aluminum atom functions as a carrier generation centre, in other words, as a leakage current path across the pn-junction. Thus, the currents of the diode of the pn-junction increase in both the forward and reverse directions. Thus increased leakage current, particularly in the forward direction, contributes to essentially eliminate the potential difference between semiconductor substrate 31' located beneath the channel and source region 6, in other words, can prevent the semiconductor substrate 31' beneath the channel 31 from its floating. Therefore, the kink phenomena can be suppressed.

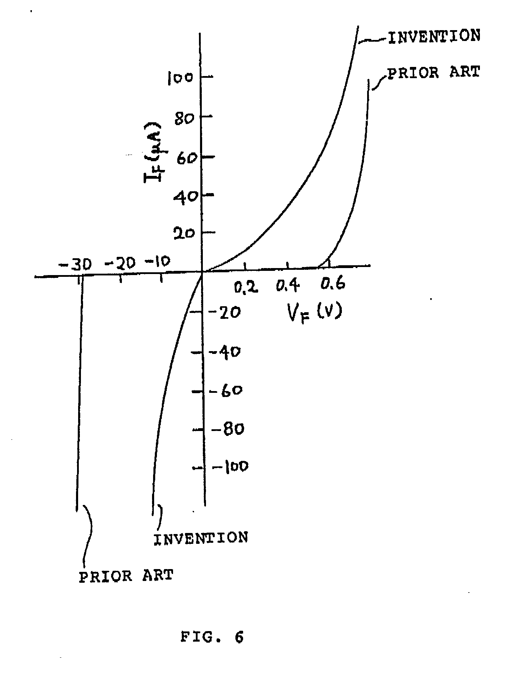

FIG. 6 shows the diode characteristics of the pn-junction of the source region in comparison to that of a prior art SOI MOS transistor, where $V_F$ denotes the forward voltage in volt and $I_F$ denotes a forward current in micro ampere of the diode of the the pn-junction. The diode characteristics is measured with an experimentally provided contact electrode (not shown in the figure) which leads out the semiconductor substrate. It is also observed in drain voltage versus drain current characteristics (not shown) that an SOI MOS transistor to which aluminum ion has been implanted according to the present invention reduces by 20% in the increase in the drain current caused from the kink phenomena, accordingly reduces by 15% in the overshoot in its pulse operation.

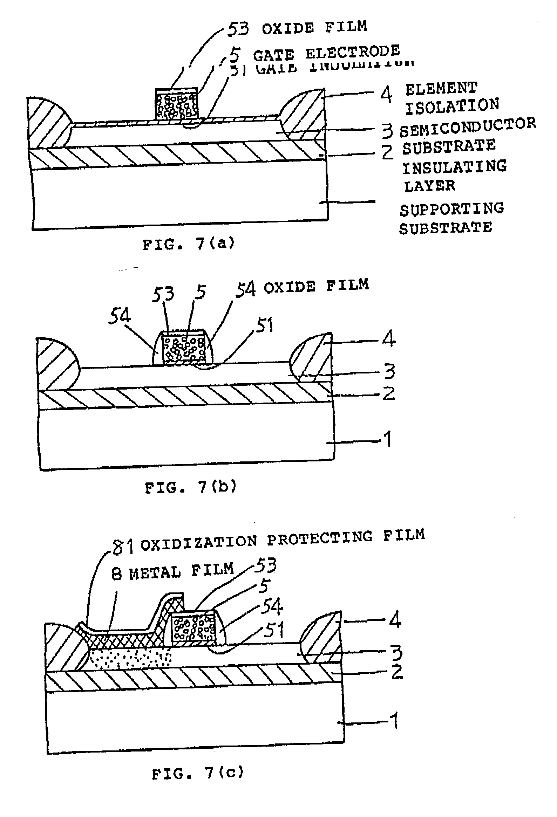

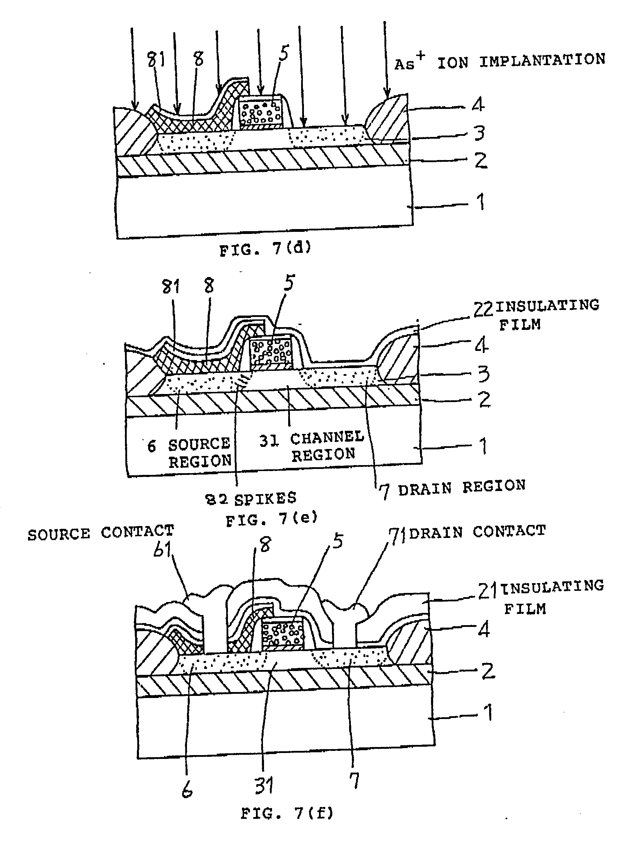

FIGs. 7 show cross-sectional side views of the fabrication steps of a second preferred embodiment of the present invention. The SOI substrate composed of supporting substrate 1 of silicon, insulating layer 2, and semiconductor substrate 3 of p-silicon are essentially the same as those of the first preferred embodiment shown in FIGs. 4. Moreover, as shown in FIG. 7(a), the steps of fabricating element insulation 4, gate insulation 51, gate electrode 5 formed of polycrystalline silicon and oxide film 53, are fabricated upon the SOI substrate according to well-known techniques. Next, as shown in FIG. 7(b), an oxide film 54 is formed on side walls of gate electrode 5 according to a well-known technique. Next, according to a CVD method, tungsten (W) film 8 is deposited as thick as, for example 3000 Å, on FIG. 7(b) substrate, and $Si_3N_4$ (silicon nitride) film 81 is deposited entirely thereon as an oxidization protection film as thick as, for example 500 Å. Tungsten film 8 and $Si_3N_4$ film 81 are then patterned with a well-known photo-lithography technique so as to be left only upon an area to be source region as shown in FIG. 7(c). Thus patterned substrate is then heated in nitrogen gas as high as typically 1100 °C for 30 minutes. This heat process causes the tungsten deposited on the surface to diffuse into a part of the semiconductor substrate to be a source region 6. Next, as shown in FIG. 7(d), arsenic ion ($As^+$) is implanted onto the entire surface of FIG. 7(c) substrate at typically 100 keV and $5 \times 10^{15}$ $cm^{-2}$ in dose. Next, FIG. 7(d) substrate is deposited with a typically 1000 Å thick $SiO_2$ insulating film 22 according to a CVD method as shown in FIG. 7(e), and is heated in a nitrogen gas at typically 1000 °C for 20 minutes. This heat process causes the arsenic impurity to diffuse to form a source region 6 as well as a drain region 7. Semiconductor impurity concentration is now $1.5 \times 10^{20}$ $cm^{-3}$ of arsenic in the source and drain regions. During this heat process, the tungsten diffuses in the source region so that the impurities precipitate to generate spikes across the pn-junction between the source region 6 and channel region 31, because the impurity concentration is larger than solid solubility of the impurities. Next, as shown in FIG. 7(f), in the same way as those of the first preferred embodiment, an insulating film 22 of PSG is deposited entirely thereon; contact holes are opened so as to expose source region 6 and drain region 7; aluminum is sputtered entirely thereon; the sputtered aluminum is patterned so as to form a source contact electrode 61 and a drain contact electrode 71. Plan layout of the source 6, the drain 7 and the gate electrode 5 is identical to that of the first preferred embodiment. In this configuration, the precipitated impurity spikes provides current paths across the pn-junction for both the forward and reverse diode characteristics of the pn-junction, resulting in the same advantageous effect as that of the first preferred embodiment.

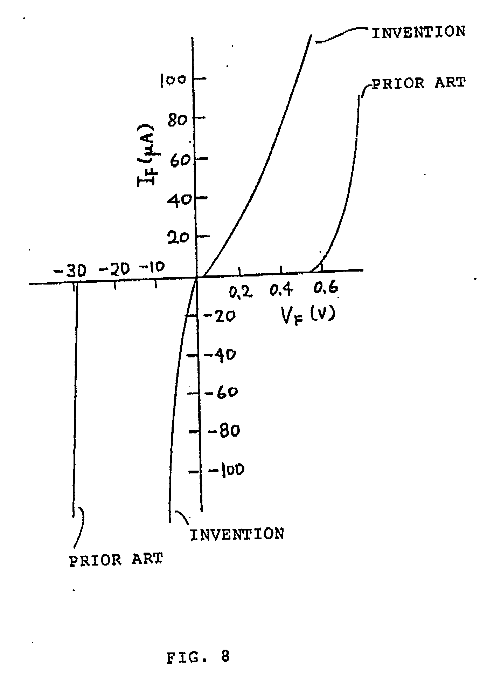

FIG. 8 shows the diode characteristics of the pn-junction of the source region of an SOI MOS transistor according to the second preferred embodiment of the present invention in comparison to that of a prior art SOI MOS transistor. The diode characteristics is measured the same way as the characteristics of FIG. 6. It is also observed in drain voltage versus drain current characteristics (not shown) that an SOI MOS transistor according to the second embodiment reduces by 20% the increase in the drain current caused from the kink phenomena, accordingly reduces by 15% in the overshoot in a pulse operation.

A third preferred embodiment of the present invention is hereinafter described (no drawing is shown therefor). The third preferred embodiment is such that the aluminum ion implantation into the source region shown in FIGs. 4(b) step is replaced with $As^+$ ion implantation of more than 10 times in dose of that for the drain region, that is, approximately $10^{17}$ $cm^{-2}$ in dose. Next, the doped substrate is heated in a nitrogen gas at, for example approximately 950 °C, 30 minutes. Thus excess dopant much more than normal impurity concentration does not form a normal pn-junction, i.e. normal diode, and generates a carrier generation centre at the pn-junction so as to cause a leakage current in both the forward and reverse characteristics of the pn-junction diode. The leakage currents contribute to eliminate the potential difference between the semiconductor substrate 31′ beneath the channel region 31 and the potential of source region 6, resulting in the same advantageous effect of the first and second preferred embodiments.

A fourth preferred embodiment of the present invention is hereinafter described (no drawing is shown therefor). In place of the aluminum ion implantation for the above-described first preferred embodiment of the present invention, an oxygen ion or a carbon ion may be implanted into the source region. The oxygen atom, or the carbon atom, combined with silicon atoms in the source region generates crystal defects therein. Thus generated crystal defects provides carrier generation centres at the pn-junction of the source region so as to provide leakage path across the pn-junction for some degree. However, the effect is not so much as the metal impurities of the first and second preferred embodiments.

Though in the above-described first, second and fourth preferred embodiments the additional impurity doped into the source region is single, such as only aluminum, tungsten or carbon, a plurality of these impurities may be doped into the source region, such as aluminum + tungsten, tungsten + carbon, tungsten + titanium, tungsten + oxygen and so on. The advantage of the plural additional dopants is an effective increase in the leakage current.

A fifth preferred embodiment of the present invention is hereinafter described (no drawing is shown therefor). A substrate which is before the resist formation and the aluminum ion implantation into source region shown in FIGs. 4(b) step of the first preferred embodiment, is implanted with the arsenic ion equally into both the region to be a source region and the region to be a drain region under the same condition as in FIG. 4(c) step. Next, while the drain region is masked like in FIG. 4(b) step, argon ion is implanted only into the source region at typically 100 keV $10^{16}$ $cm^{-2}$ in dose, so as to make the silicon of the source region amorphous. The argon ion does not chemically react with the implanted silicon. Thus formed amorphous silicon in the source region causes crystal defects therein; accordingly, a carrier generation centre is formed at the pn-junction so as to provide current leakage path across the pn-junction diode, and contribute to eliminate potential difference between the source region 6 and the semiconductor substrate 31′ beneath the channel region 31, resulting in the same advantageous effect as of the above-described preferred embodiments.

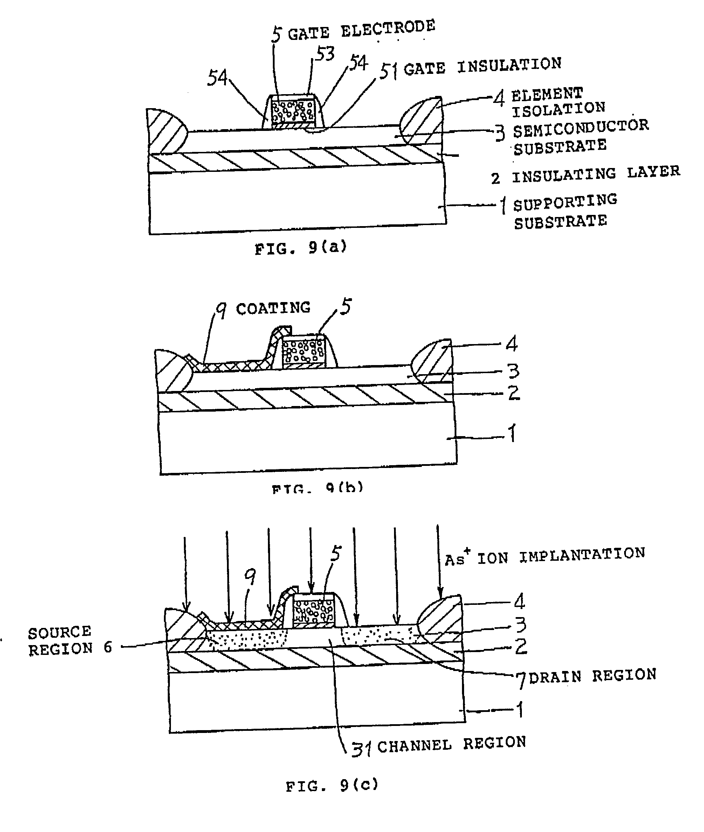

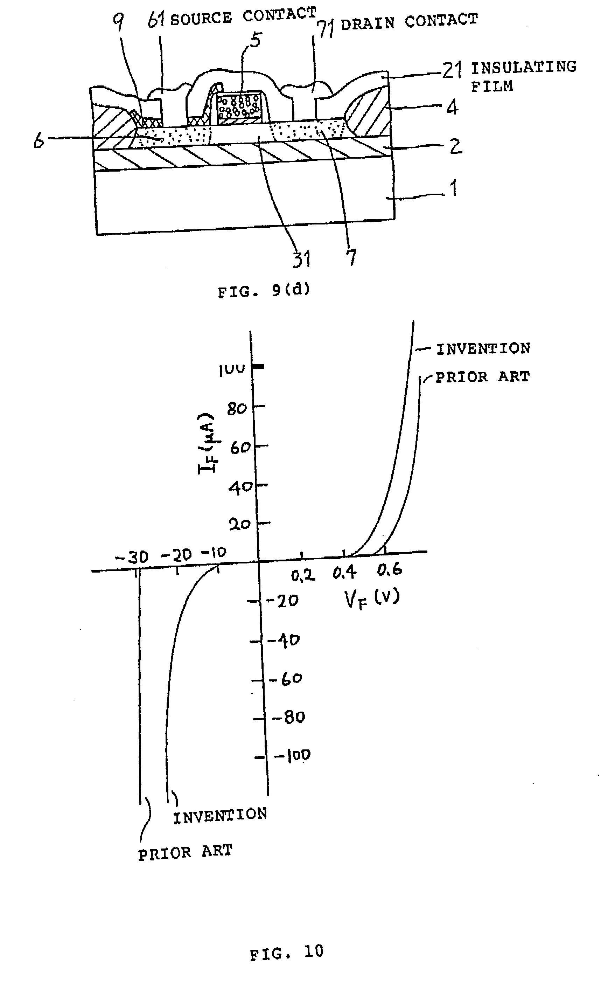

FIGs. 9 show cross-sectional side views of the fabrication steps of a sixth preferred embodiment of the present invention. As shown in FIG. 9(a), upon an SOI substrate composed of supporting substrate 1 of silicon; there are formed insulating layer 2 of $SiO_2$ and semiconductor substrate 3, element isolation region 4; gate insulation 51; gate electrode 5 formed of polycrystalline silicon and oxide films 53 and 54 in the essentially same ways as those shown in FIGs. 7(a) and 7(b) for the second preferred embodiment. Next, according to a well-known CVD method and a photo-lithography technique a typically 3000 Å $Si_3N_4$ coating 9 is formed upon a portion of the semiconductor substrate to be a source region as shown in FIG. 9(b). Next, arsenic ion ($As^+$) is implanted into the entire surface of thus prepared substrate at the condition of typically 100 keV, $5 \times 10^{15}$ $cm^{-2}$ in dose as shown in FIG. 9(c). The thus ion-implanted substrate is heated at typically 950°C, for 30 minutes so that the implanted arsenic diffuses to form a source region 6 and a drain region 7. Next, as shown in FIG. 9(d), a PSG film 21 is coated over the entire surface as an insulating film; contact holes are opened so as to expose the source and drain regions; aluminum is sputtered thereon and patterned so as to form a source contact 61 and a drain contact 71, according to essentially the same ways as those of the first preferred embodiment embodiment. Thermal expansion coefficients of each material of source region 6, drain region 7, coating 9 and insulating film 21 are as follows:

| Item | Material | Thermal Expansion Coef. |
|---|---|---|
| 6 source region | p-Si | $2.6 \times 10^{-6}/^{\circ}C$ |
| 7 drain region | p-Si | $2.6 \times 10^{-6}/^{\circ}C$ |
| 9 coating | $Si_3N_4$ | $4 \times 10^{-6}/^{\circ}C$ |
| 21 insulating film | PSG | $4 \times 10^{-6}/^{\circ}C$ |

As seen in the above table, the difference of the thermal expansion coefficients of source region 6 and coating 9 thereon is larger than the difference of the thermal expansion coefficients of drain region 7 and insulating film 21 coated thereon. Therefore, there is generated more internal-stress in source region 6 than in drain region 7. This internal stress causes a piezo-resistive effect. The piezo-resistive effect has been generally explained that the internal stress alters the forbidden band width at the pn-junction resulting in a change of the intrinsic carrier density, accordingly alters the pn-junction diode characteristics so as to increase a leakage current in both junction.

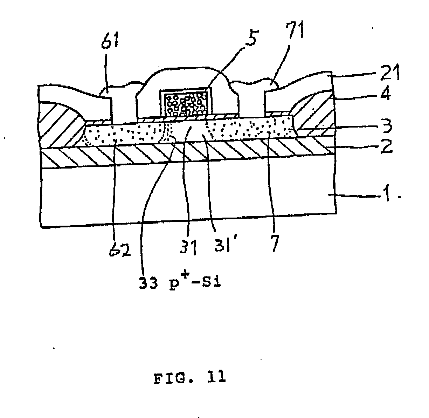

FIG. 10 shows the diode characteristics of the pn-junction of the source region of an SOI MOS transistor according to the sixth preferred embodiment of the present invention in comparison to that of a prior art SOI MOS transistor. The diode characteristics is measured the same way as that of FIG. 6 characteristics. It is also observed in drain voltage versus drain current characteristics (not shown) that an SOI MOS transistor to which thermal stress is imposed according to the present invention reduces by 15% in the increase in the drain current caused from the kink phenomena, accordingly reduces by 10% in the overshoot in its pulse operation.

FIG. 11 shows cross-sectional side view of a seventh preferred embodiment of the present invention. Element insulation 4, gate insulation 51, and gate electrode 5 formed of polycrystalline silicon are fabricated on an SOI substrate composed of supporting substrate 1 of silicon, insulating layer 2 and semiconductor substrate 3 of p-silicon essentially in the same way as those of the first preferred embodiment shown in FIG. 4(a). Next, after a resist is patterned over the portion other than the portion to be a source region, boron ion is implanted into the portion to be source region by the condition of typically 50 keV, $1 \times 10^{15}$ $cm^{-2}$ in dose, instead of aluminum ion implantation shown in FIG. 4(b). Next, in the essentially same way of the first preferred embodiment, after removing the resist, arsenic ions ($As^+$) as n-type dopant are implanted into the entire surface at the condition of typically 100 keV and $5 \times 10^{15}$ $cm^{-2}$ in dose. Exposed surfaces of the polycrystalline silicon gate electrode 5 are oxidized according to a well-known heat process so as to form insulating oxide films. By this heat process, the ion-implanted boron and arsenic, are diffused so that the boron forms a higher-doped $p^+$ region 33 in the p-Si substrate 3, and the arsenic forms a source region 62 and a drain region 7. Thus, impurity concentrations are typically $1.5 \times 10^{20}$ $cm^{-3}$ of arsenic in the drain region 7 and source region 6, and at least $1 \times 10^{18}$, typically, $2 \times 10^{19}$ $cm^{-3}$ of boron in the higher doped region 33 while the p-Si substrate has been having a concentration of $10^{16}$ $cm^{-3}$. Thus, a tunnel diode is formed at the pn-junction. Furthermore, in the same way as in the first preferred embodiment, a PSG insulating film 21, source contact 61, drain contact 71 and gate electrode 55 are formed according to a well-known technique. In the thus fabricated transistor, a tunnel current is generated through the pn-junction of the source region 62. The tunnel current functions so as to reduce the potential difference between the source region 62 and the region 31' beneath the channel region 31 in semiconductor substrate 3, resulting in an advantageous effect that the kink effect is reduced as in the above preferred embodiments. In order to realize the concept of the seventh preferred embodiment, the structure of the tunnel diode is not limited to that disclosed above, as long as a tunnel diode is formed at the pn-junction of the source region.

Though in the above-described preferred embodiments aluminum and tungsten are referred to as the metal impurity to cause the leakage across the pn-junction other metals, such as molybdenum, platinum, titanium and tin, and their combination can be employed in place of aluminum or tungsten in the first, second, fourth and fifth preferred embodiments.

Though in the above-described preferred embodiments p-type silicon is referred to as the semiconductor substrate 3, it is apparent that the concept of the present invention may be embodied in an SOI type insulated-gate transistor fabricated on an n-type silicon substrate. Then, the dopant to form the source and drain regions may be boron. The metal impurity to cause the leakage current across the pn-junction may be the same as those used for the p-silicon substrate. The dopant to form the higher doped region, in this case an $n^-$-Si region, in the semiconductor substrate 3 as a variation of the seventh preferred embodiment may be arsenic or phosphorus. The conditions of ion implantation, as well as heat process, may also be the same.

Though in the above-described preferred embodiments a silicon plate and silicon dioxide formed thereon are referred to as the insulating substrate of SOI structure, it is apparent that the concept of the present invention may be embodied in an insulated-gate transistor formed on other kinds of SOI substrate.

The many features and advantages of the invention are apparent from the detailed specification and thus, it is intended by the appended claims to cover all such features and advantages of the system which fall within the true spirit and scope of the invention Further, since numerous modifications and changes may readily occur to those skilled in the art, it is not desired to limit the invention to the exact construction and operation shown and described, and accordingly, all suitable modifications and equivalents may be resorted to, falling within the scope of the invention.

## Claims

1. An insulated gate field-effect transistor formed on a semiconductor layer having a first conductivity type on an insulating substrate comprising:
a drain region doped with a first impurity having a second conductivity type opposite said first conductivity type;
a gate electrode formed over a channel region formed in said semiconductor layer via a gate insulation layer, said channel region being adjacent to said drain region; and
a source region doped with said first impurity, said source region being adjacent to said channel region oppositely to said drain region, a first pn-junction formed between said source region and said semiconductor layer, said pn-junction having a carrier generation centre so as to provide a current path across said first pn-junction;
whereby an electrical resistance across said first pn-junction is less than an electrical resistance across a second pn-junction formed between said drain region and said semiconductor layer.

2. An insulated-gate field-effect transistor as claimed in claim 1, wherein said carrier generation centre comprises a metal impurity doped in said source region.

3. An insulated-gate field-effect transistor as claimed in claim 2, wherein said metal impurity is introduced by means of ion implantation into said first pn-junction.

4. An insulated-gate field-effect transistor as claimed in claim 2 or 3, wherein amount of metal impurity by said ion implantation is more than solid solubility of said metal impurity.

5. An insulated-gate field-effect transistor recited in claim 2, wherein said metal impurity is diffused from a metal layer deposited over said source region through said source region to said first pn-junction by a heat process.

in claim 2, wherein said metal impurity is precipitated across said first pn-junction.

7. An insulated-gate field-effect transistor as claimed in any of the claims 2 to 6, wherein said source region comprises at least one more kind of metal impurities than said drain region.

8. An insulated-gate field-effect transistor as claimed in any of the claims 2 to 7, wherein said metal impurity is chosen from a group of aluminium, molybdenum, platinum, tin, titanium, and tungsten.

9. An insulated-gate field-effect transistor as claimed in any of the preceding claims, wherein concentration of said first impurity in said source region is higher than that in said drain region so as to provide a carrier generation centre at said first pn-junction.

10. An insulated-gate field-effect transistor as claimed in claim 9, wherein said concentration of said first impurity in said source region is more than 10 times of the concentration in said drain region.

11. An insulated-gate field-effect transistor as claimed in any of the preceding claims, wherein said source region is essentially formed of an amorphous semiconductor material.

12. An insulated-gate field-effect transistor formed on a semiconductor layer having a first conductivity type on an insulating substrate, comprising:
a drain region doped with a first impurity having a second conductivity type opposite said first conductivity type;
a gate electrode formed over a channel region formed in said semiconductor layer via a gate insulation layer, said channel region being adjacent to said drain region; and
a source region doped with said first impurity, said source region being adjacent to said channel region oppositely to said drain region, said source region having a thermal stress therein higher than that in said drain region so as to cause a piezoresistive effect,

7

whereby an electrical resistance across said first pn-junction is less than an electrical resistance across a second pn-junction formed between said drain region and said semiconductor layer.

13. An insulated-gate field-effect transistor as claimed in claim 12, further comprising:
a layer formed on said source region without being formed on said drain region, said layer having a thermal expansion coefficient different from thermal expansion coefficient of said source region.

14. An insulated-gate field-effect transistor formed on a semiconductor layer having a first conductivity type on an insulating substrate, comprising:
a drain region doped with a first impurity having a second conductivity type opposite the first impurity type;
a gate electrode formed over a channel region formed in said semiconductor layer via a gate insulation layer, said channel region being adjacent to said drain region; and
a source region doped with said first impurity, said source region being adjacent to said channel region oppositely to said drain region, and
a tunnel diode formed at a first pn-junction formed between said source region and said semiconductor layer, so as to provide a tunnel current path across said first pn-junction,
whereby an electrical resistance across said first pn-junction is less than an electrical resistance across a second pn-junction formed between said drain region and said semiconductor layer.

15. An insulated-gate field-effect transistor as claimed in claim 14, wherein said tunnel diode comprises a portion in said semiconductor layer in a vicinity of said first pn-junction, said portion being further doped with a second impurity having the first conductivity type.

16. An insulated-gate field-effect transistor as claimed in claim 1, 12 or 14, wherein said insulating substrate is essentially comprises a silicon body and a silicon dioxide layer formed thereon.

17. An insulated-gate field-effect transistor as claimed in claim 1, 12 or 14, wherein said semiconductor layer comprises a silicon material.

6

FIG. 1

FIG. 2

PRIOR ART

FIG. 3(a)

55. CONTACT OF
GATE ELECTRODE

32 CONTACT OF
SEMICONDUCTOR SUBSTRATE

( b )

PRIOR ART

FIG. 3(b)

5 GATE ELECTRODE

51 GATE INSULATION

4 ELEMENT ISOLATION

3 SEMICONDUCTOR
SUBSTRATE

2 INSULATING LAYER

1 SUPPORTING
SUBSTRATE

FIG. 4(a)

Al$^+$ ION IMPLANTATION

5    51

RESIST

4

3

2

1

FIG. 4(b)

As$^+$ ION IMPLANTATION

5    51

4

3

2

1

FIG. 4(c)

52 OXIDE FILM

6 SOURCE
REGION

31 CHANNEL REGION

5

7 DRAIN REGION

4

3

2

1

FIG. 4(d)

61 SOURCE
CONTACT

5

71 DRAIN CONTACT

21 INSULATING
FILM

4

3

2

1

6    31'  31              7

FIG. 4(e)

55 GATE CONTACT

5 GATE ELECTRODE

SOURCE 6

7 DRAIN

61
SOURCE
CONTACT

71 DRAIN CONTACT

FIG. 5

FIG. 6

53 OXIDE FILM

5 GATE ELECTRODE

51 GATE INSULATION

4 ELEMENT ISOLATION

3 SEMICONDUCTOR

2 SUBSTRATE
INSULATING LAYER

SUPPORTING SUBSTRATE

FIG. 7(a)

53 5 54 OXIDE FILM

54 51

4

3

2

1

FIG. 7(b)

81 OXIDIZATION PROTECTING FILM

8 METAL FILM 53

5

54

51

4

3

2

1

FIG. 7(c)

As$^+$ ION IMPLANTATION

81
8
5
4
3
2
1

FIG. 7(d)

81
8
5
22 INSULATING FILM
4
3
2
1

6 SOURCE REGION
31 CHANNEL REGION
82 SPIKES
7 DRAIN REGION

FIG. 7(e)

SOURCE CONTACT
61
8
5
71 DRAIN CONTACT
21 INSULATING FILM
4
2
1

6
31
7

FIG. 7(f)

FIG. 8

FIG. 9(a)

5 GATE ELECTRODE
53
54
54
51 GATE INSULATION
4 ELEMENT ISOLATION
3 SEMICONDUCTOR SUBSTRATE
2 INSULATING LAYER
1 SUPPORTING SUBSTRATE

FIG. 9(b)

9 COATING
5
4
3
2
1

FIG. 9(c)

As⁺ ION IMPLANTATION
9
5
SOURCE REGION 6
4
3
2
7 DRAIN REGION
1
31 CHANNEL REGION

9    61 SOURCE CONTACT    71 DRAIN CONTACT

5

21 INSULATING
   FILM

4

6

2

1

31    7

FIG. 9(d)

— INVENTION
— PRIOR ART

$I_F$ (µA)

|00

80

60

40

20

−30  −20  −10

0.2   0.4   0.6

$V_F$ (v)

−20

−40

−60

−80

−|00

INVENTION

PRIOR ART

FIG. 10

FIG. 11